Europäisches Patentamt

European Patent Office

Office européen des brevets

(11) Veröffentlichungsnummer: **0 131 217 B1**

(12) **EUROPÄISCHE PATENTSCHRIFT**

(45) Veröffentlichungstag der Patentschrift: **12.06.91**

(51) Int. Cl.⁵: **H03M 13/00**

(21) Anmeldenummer: **84107517.9**

(22) Anmeldetag: **28.06.84**

(54) **Vieladrige Bitübertragungsanordnung insbesondere eines Fernsprech-Vermittlungssystems.**

(30) Priorität: **30.06.83 DE 3323577**

(43) Veröffentlichungstag der Anmeldung:
**16.01.85 Patentblatt 85/03**

(45) Bekanntmachung des Hinweises auf die
Patenterteilung:
**12.06.91 Patentblatt 91/24**

(84) Benannte Vertragsstaaten:
**AT BE CH DE FR GB IT LI NL SE**

(56) Entgegenhaltungen:
**DE-A- 2 160 916**
**US-A- 3 404 373**
**US-A- 4 168 486**

**IEEE TRANSACTIONS ON COMPUTERS, Band
C-24, Nr. 12, Dezember 1975, Seiten
1145-1155, New York, US; D.H. LAWRIE:
"Access and alignment of data in an array
processor"**

(73) Patentinhaber: **Siemens Aktiengesellschaft
Wittelsbacherplatz 2
W-8000 München 2(DE)**

(72) Erfinder: **Krost, Hans-Hermann, Dipl.-Ing.(FH)
Ammerseestrasse 8
W-8027 Neuried(DE)**

**Beschreibung**

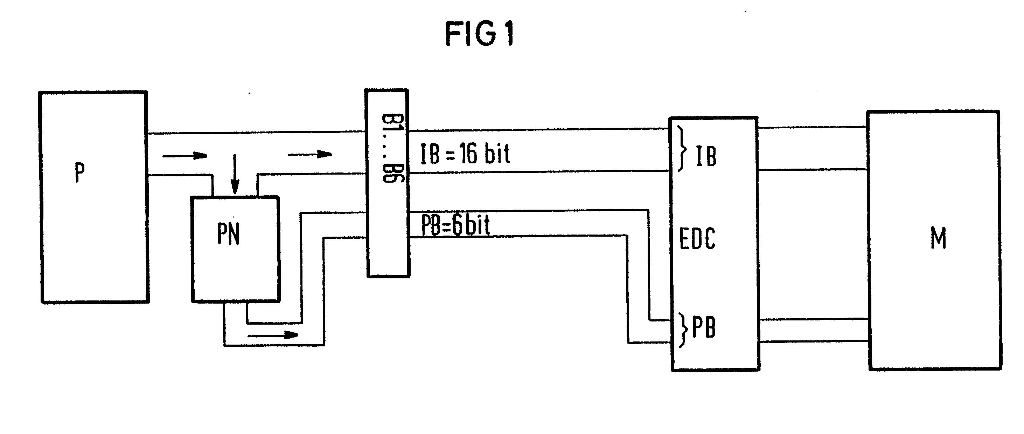

Die Erfindung geht von der im Oberbegriff des Patentanspruches 1 genannten vieladrigen Bitübertragungsanordnung aus, also einer Schaltungsanordnung, der ein EDC-Prinzip (error detection and correction = Fehleranzeige und Korrektur-Schaltungsprinzip) zugrunde liegt. Solche Bitübertragungsanordnungen sind dem Fachmann wohlvertraut, insbesondere eine spezielle Variante davon, der das SEC/DED-Prinzip (single error correcting/double error detecting) zugrunde liegt, vgl. z.B. die Patentliteratur DE-AS 12 50 163, Fig. 1; DE-OS 25 36 498, Fig. 1 bis 3; DE-PS 26 55 653; sowie die Berichte in Fachzeitschriften IBM J. of Res. and Dev.(Juli 1970), Seiten 395 bis 400; Electronics (9.November 1978) Seiten 130 bis 133; ferner die Firmenveröffentlichungen AMD, The Designers' Guide '80 (1980) Seiten 5-1 bis 5-16 und AMD, Am2960 Series, Dynamic Memory, Support Handbook (1981),Seiten 1 bis 44, welche den in Fachkreisen berühmten EDC-Baustein vom Typ Am2960 betreffen.

Solche auf dem EDC-Prinzip beruhenden Schaltungsanordnungen gestatten, nicht nur einen beachtlichen Anteil von Fehlern in parallel übertragenen Bits zu erkennen, sondern darüber hinaus sogar, jedenfalls einen Teil der erkannten Fehler selbsttätig zu korrigieren und auf diese Weise die Gefahren, welche mit fehlerhaften Übertragungen verbunden sind, einzudämmen.

Lieder erkennen die betreffenden EDC-Schaltungen nicht sämtliche Fehler, die bei der Übertragung auftreten können. Das heißt, es gibt unerkannte Fehler, besonders wenn mehrals zwei Stellen des übertragenen Wortes fehlerhaft übertragen wurden ("mehr-als-zweistelliger Fehler") - obwohl eine bestimmte Anzahl solcher vielstelliger Fehler, nämlich besondere Konfigurationen von z.B. fünfstelligen Fehlern, auch von relativ einfachen EDC-Schaltungen noch als Fehler erkannt werden können. Welche Konfigurationen von vielstelligen Fehlern noch erkannt werden und welche Konfigurationen jeweils nicht mehr als Fehler erkannt werden, kann nur anhand der jeweils verwendeten speziellen EDC-Schaltung ermittelt werden, da je nach Art der verwendeten EDC-Schaltung andere Konfigurationen erkannt werden.

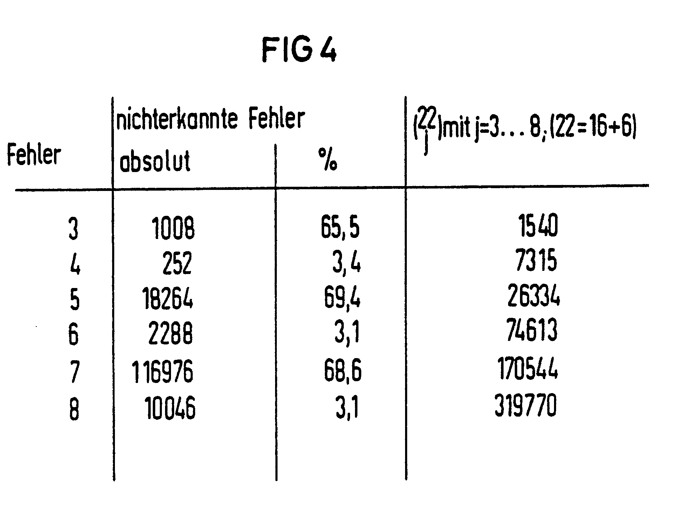

Figur 4 der vorliegenden Schrift zeigt z.B. eine Untersuchung der Verwendung des EDC-Bausteins Am2960. Wenn auch dieser Baustein die Einfach- und Zweifachfehler mit 100prozentiger Sicherheit erkennt, so werden von ihm doch besonders die Dreifach-, Fünffach- und Siebenfachfehler in rund zwei Drittel aller möglichen Fälle nicht erkannt. Von ihnen werden hingegen die meisten der verschiedenen möglichen Vierfach-, Sechsfach- und Achtfachfehler noch erkannt. Die Figur 4 gibt auch die absolute Anzahl der nichterkannten Vielfachfehler, sowie in der letzten Spalte die Anzahl der verschiedenen, insgesamt möglichen Konfigurationen von Dreifach- bis Achtfachfehlern an, wenn das übertragene Wort insgesamt 22 Bits, nämlich 16 Informationsbits und sechs,einem speziellen Code dieses Bausteins entsprechende Paritätbits aufweist.

Die Aufgabe der Erfindung ist: Bei der parallelen Übertragung sehr breiter, also z.B. zweiundzwanzigstelliger, Worte über mehrere parallel betriebene, hinsichtlich Stellenanzahl für sich zu kleine Schaltungsanordnungsbausteine,
- wenn also ein solcher Schaltungsanordnungsbaustein, für sich betrachtet, jeweils nur z.B. maximal vier der zweiundzwanzig Bits, also nur einen Teil der insgesamt parallel übertragenen Bits an die EDC-Schaltung weiterleitet,

soll die Sicherheit erhöht werden, mit der jene vielstelligen, insbesondere jene mehr-als-zweistelligen, Fehler, die für sich schon ein völliger Ausfall eines einzigen derartigen Schaltungsanordnungsbausteins hervorruft, erkannt werden.

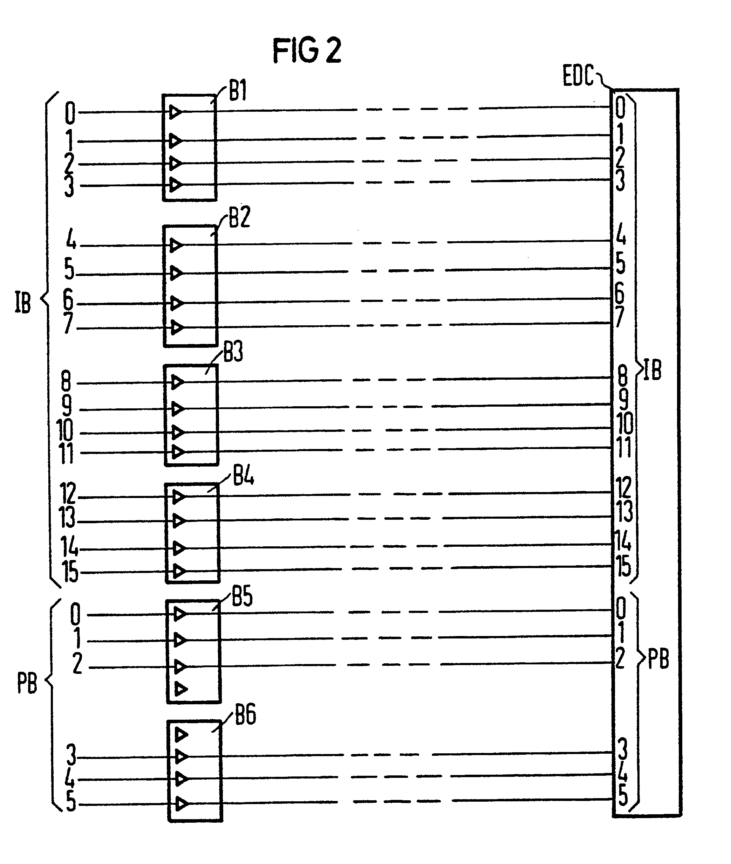

Die Aufgabe der Erfindung wird genauer anhand von Fig. 2 der vorliegenden Schrift erläutert, welche eine nichterfindungsgemäße Bitübertragungsanordnung zeigt. Diese Fig. 2 zeigt die EDC-Schaltung EDC mit in diesem Fall sechzehn Eingängen für die Informationsbits IBO...15 und sechs Eingänge für zugehörige Paritätbits PBO...5, also eine EDC-Schaltung, wie sie insbesondere durch den EDC-Baustein Am2960 realisiert sein kann. Die 22 verschiedenen Adern zur parallelen Übertragung dieser 22 Bits führen gemäß Fig. 2 über sechs verschiedene, Parallel betriebene Schaltungsanordnungsbausteine B1...6, welche im vorliegenden Fall jeweils maximal vier ausgenutzte Verstärker enthalten und welche im vorliegenden Fall also z.B. durch die Bausteine vom Typ 74F244, z.B. hergestellt durch die Firma Fairchild, realisiert sein können. - Bei der Erfindung muß es sich jedoch allerdings nicht immer nur um Verstärker bei den Schaltungsanordnungsbausteinen B1...6 handeln. Diese Bausteine können bei der Erfindung auch beliebige andere bitindividuelle Schaltungsanordnungen enthalten, z.B. statt mehreren bitindividuellen Verstärkern jeweils mehrere bitindividuelle Registerzellen enthalten, oder mehrere bitindividuelle Speicherbaustein-Speicherzellen, also z.B. entsprechend Fig. 2 jeweils vier simultan angesteuerte Speicherzellen auf sechs verschiedenen Speicherbausteinen B1...6 enthalten.

Würde man nun die Schaltungsanordnungsbausteine B1...6 entsprechend Figur 2 in der gezeigten nichterfindungsgemäßen Weise in die Adern einfügen, dann würden alle diese sechs Schaltungsanordnungsbausteine - die jeweils für sich mehrere parallel betriebene bitindividuelle Schaltungsanordnungen enthalten, nämlich im vorliegenden Fall vier bzw. drei ausgenutzte bitindividuelle parallel betriebene Schaltungsanordnungen enthalten - jeweils stets vier bzw. jeweils stets drei unter sich benachbarte Stellen der EDC-Schaltungseingänge,bzw. jeweils stets vier bzw. jeweils stets drei benachbarte Stellen des hier insgesamt zweiundzwanzigstelligen Wortes übertragen. Bei einer solchen Bitübertragungsanordnung würden durch einen völligen Ausfall eines der Bausteine B1 bis B6 jeweils bis zu vier einander benachbarte Stellen über den ausgefallenen Bausteins "übertragenen" Wortes verfälscht,wobei nur einzelne Konfigurationen,aber nicht alle Konfigurationen, dieser Verfälschungen von der EDC-Schaltung EDC als fehlerhafte Übertragungen erkannt würden. Ein einziger (!) Fehler bei der Übertragung, nämlich der völlige Ausfall eines gesamten Bausteins, z.B. ein Ausfall des Bausteines B1, würde also nicht mehr mit hoher Sicherheit sofort,z.B. von einer einfachen SEC/DED-Schaltung, als fehlerhafte Übertragung erkannt. Die Sicherung einer Übertragung nach dem EDC-Prinzip versagt also bei einem solchen Ausfall zu oft,sobald dadurch mehr als zwei fehlerhafte Bits in vieladrigen Datenbus durch den Ausfall eines mehr als zwei Datenbits übertragenden Schaltungsanordnungsbausteins, vgl. B1,auftreten.

Die Erfindung ermöglicht also entsprechend ihrer schon oben angegebenen Aufgabe unter Beibehaltung der 100 %igen Erkennung von mindestens zwei fehlerhaft übertragenen Stellen nach dem üblichen EDC-Prinzip, z.B. nach dem SEC/DED-Prinzip,auch noch-höher-stellige Fehler, also z.B. mehr-als-zwei-stellige Fehler, wie dreistellige und vierstellige Fehler, mit - im Vergleich zu einer Bitübertragungsanordnung gemäß Fig. 2 - erhöhter Sicherheit zu erkennen, wenn sie durch den Ausfall eines der Schaltungsanordnungsbausteine B1...6 hervorgerufen werden.

Diese Aufgabe wird durch die im Patentanspruch 1 angegebenen Maßnahmen gelöst. Die Lösung beruht also,abweichend von der in Fig. 2 gezeigten Anordnung, insbesondere auf einer speziellen Verschachtelung bzw. Aufteilung der Informationsbits und Paritätbits auf die verschiedenen Schaltungsanordnungsbausteine, wobei die Verschachtelung so gewählt ist, daß der Ausfall eines dar Schaltungsanordnungsbausteine mit erhöhter Sicherheit von der EDC-Schaltung EDC erkannt wird - also mit höherer Sicherheit, als er bei direkter Übertragung gemäß Fig.2 erkannt würde.

Die in dem abhängigen Anspruch 2 angegebene Weiterbildung der Erfindung hat den zusätzlichen Vorteil, nämlich daß die Sicherheit der Erkennung des Ausfalls eines Schaltungsanordnungsbausteines zusätzlich dadurch erhöht wird, daß die Anzahl der parallelbetriebenen Schaltungsanordnungen pro Schaltungsanordnungsbaustein besonders klein gemacht wird, nämlich hier nur noch vier beträgt.

Die Erfindung wird anhand der Figuren näher erläutert, wobei Figur

1 allgemein eine Bitübertragungsanordnung, bei der die Bitübertragung sowohl gemäß Fig. 2, als auch erfindungsgemäß angeordnet werden kann,

2 eine bereits erläuterte, nicht erfindungsgemäße Bitübertragungsanordnung,

3 ein Beispiel für eine erfindungsgemäße Bitübertragungsanordnung und

4 eine bereits erläuterte Tabelle über den Grad der Zuverlässigkeit, mit der mehr-als-zwei-stellige Fehler vom EDC-Baustein Am 2960 erkannt werden,

zeigen.

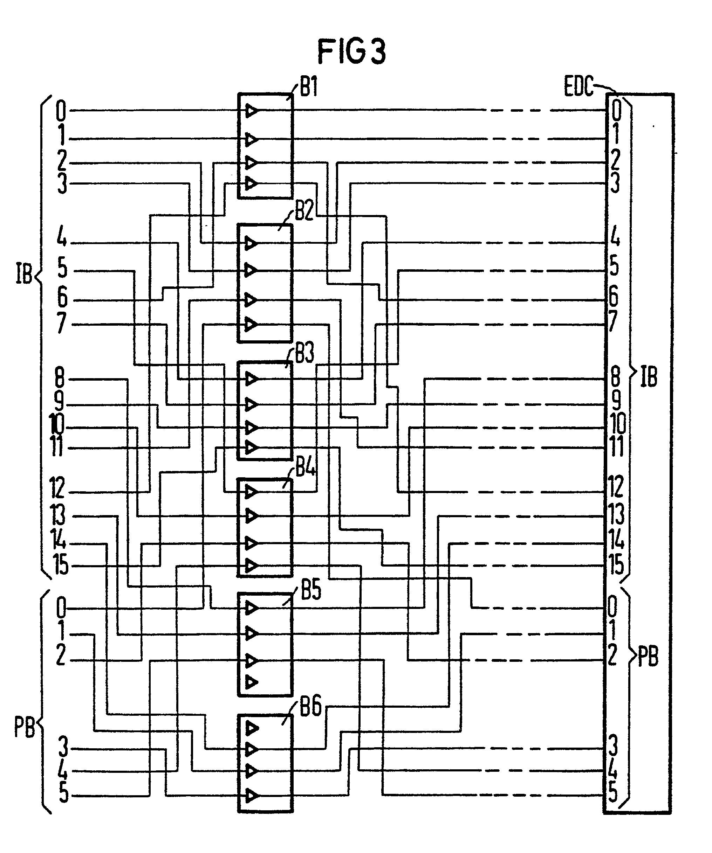

Figur 1 zeigt also ein Beispiel für eine Bitübertragungsanordnung, welche sowohl nicht erfindungsgemäß entsprechend Fig. 2, als auch erfindungsgemäß entsprechend z.B. Fig. 3, im wichtigsten Teil ihrer Übertragungsstrecke aufgebaut sein kann. Das Bauteil P, z.B. ein Prozessor P, liefert an seinem Ausgang Informationsbits, und zwar z.B. 16 parallel zu übertragende Informationsbits IB, welche zusätzlich in einem Paritätnetzwerk PN, z.B. mit Hilfe des EDC-Bausteins Am2960, durch Bildung von Paritätbits PB, z.B. sechsstelligen Paritätbits PB, ergänzt werden. Die Informationsbits IB und Paritätbits PB werden dann parallel über Bausteine, hier in Fig. 1 als Beispiel über die Bausteine B1...B6, zu einem anderen Organ M, z.B. zu einen Speicher M, übertragen, wobei ein EDC-Baustein EDC die Informationsbits IB mit Hilfe der Paritätbits PB auf Fehlerfreiheit überprüft und ggf. sogar korrigiert, soweit dieser EDC-Baustein EDC dazu jeweils in der Lage ist.

Anhand von Fig. 2 wurde bereits erläutert, daß der Ausfall eines der parallelbetriebenen Bausteine B1...B6 einer solchen, in Fig. 1 gezeigten Bitübertragungsanordnung häufig dazu führt, daß der Ausfall nur mit sehr unbefriedigender Wahrscheinlichkeit sofort erkannt wird, was auch oben anhand von Fig. 4 für ein spezielles Beispiel exakt zahlenmäßig belegt wurde.

Das in Fig. 3 gezeigte Beispiel einer erfindungsgemäßen Bitübertragungsanordnung enthält Vier-Bitverstärker-Bausteine B1...B6 als Schaltungsanordnungsbausteine - die Schaltungsanordnungen der betreffenden Bausteine stellen also einfache Verstärker dar. Jeder Baustein enthält maximal vier solche Bitverstärker, nämlich drei oder vier Bitverstärker, welche in Adern der Bitübertragungsanordnung eingefügt sind. Grundsätzlich kann jedoch die Schaltungsanordnung, jeweils für sich betrachtet, beliebig sein, also statt durch einen Bitverstärker z.B. durch eine Speicherzelle oder Registerzelle gebildet sein. Bei dem in Fig. 3 gezeigten Beispiel sind, ebenso wie bei dem in Fig.2 gezeigten Beispiel, insgesamt sechzehn Adern für die Informationsbits IB0...15, sowie sechs Adern für die Paritätbits PB0...5 angebracht, wobei der EDC-Baustein EDC,der in Fig. 3 und Fig. 1 gezeigt ist, erfindungsgemäß mit erhöhter Sicherheit den Ausfall eines der Bausteine B1...B6 erkennen soll.

Übrigens kann das in Fig. 3 gezeigte Beispiel auch durch käufliche Bausteine realisiert werden, nämlich insbesondere mit dem EDC-Baustein Am2960, welcher z.B. von der Firma AMD hergestellt wird, sowie mit Hilfe der Bitverstärkerbausteine 74F244, welcher z.B. von der Firma Fairchild hergestellt wird, vgl. insbesondere die entsprechenden Firmendruckschriften zu den betreffenden Bausteinen.

Zur Erhöhung der Sicherheit der Erkennung des Ausfalls eines der Schaltungsanordnungsbausteine wird erfindungsgemäß also zumindest ein Großteil, wenn nicht alle, der parallelbetriebenen bitindividuellen Schaltungsanordnungen, die auf mehrere Schaltungsanordnungsbausteine B1...B6 mit jeweils maximal bis zu n parallelbetriebenen bitindividuellen Schaltungsanordnungen so verteilt, daß höchstens ein Teil der Schaltungsanordnungsbausteine, insbesondere kein einziger dieser Schaltungsanordnungsbausteine B1...B6, aus n-benachbarten Stellen, z.B. aus den vier benachbarten Stellen IB0...IB3, der EDC-Schaltungseingänge jeweils mehr als zwei dieser Stellen der EDC-Schaltungseingänge mit Bits beliefert. Bei dem in Fig. 3 gezeigten Beispiel beträgt n jeweils vier , wobei gem. Fig. 3 kein einziger der Schaltungsanordnungsbausteine B1...B6 mehr als zwei benachbarte Stellen von jeweils vier benachbarten Stellen der EDC-Schaltungseingänge mit Bits beliefert.

Bei dem in Fig. 3 gezeigten Ausführungsbeispiel übertragen nämlich die Bitverstärker des ersten Bausteins B1 die Informationsbitstellen IB0, IB1, IB6 und IB12, ferner die Bitverstärker des zweiten Bausteins B2 die Informationsbitstellen IB2, IB3 und IB11 sowie die Paritätbitstelle PB0, ferner die Bitverstärker des dritten Bausteins B3 die Informationsbitstellen IB4, IB7, IB9 und IB15, ferner die Bitverstärker des vierten Bausteins B4 die Informationsstellen IB5, IB10 sowie die Paritätbitstellen PB2 und PB4, ferner die Bitverstärker des fünften Bausteins B5 die Informationsbitstellen IB8 und IB13 sowie die Paritätbitstelle PB5, sowie die Bitverstärker des sechsten Bausteins B6 die Informationsbitstelle IB14 und die Paritätbitstellen PB1 und PB3.

Durch Versuch, oder auch durch Berechnung, kann man, je nach dem verwendeten EDC-Baustein EDC, sowie je nach dem zugehörigen Code zur Bildung der Paritätbits PB und je nach der Anzahl der Informationsbitstellen IB jeweils recht rasch eine erfindungsgemäße Verschachtelung für die Einfügung der Schaltungsanordnungen in die Adern der Bitübertragungsanordnung finden. Die in Fig. 2 dargestellte erfindungsgemäße Lösung für eine sechszehnstellige Informationsbitübertragung mit Hilfe des Bausteins Am2960 und dem für diesen Baustein vorgeschriebenen Code für die Paritätbits PB wurde sogar so gewählt, daß damit nicht nur eine erhöhte Sicherheit, sondern sogar für eine 100 %ige Sicherheit der sofortigen Erkennung des Ausfalls eines der Schaltungsanordnungsbausteine B1...B6 erreicht wurde - die in Fig. 3 angegebene Lösung erreicht sogar eine 100 %ige Ausfallerkennungssicherheit eines beliebigen der sechs Bausteine B1...B6. Zur raschen rechnerischen Ermittlung wurde die innere Schaltung des EDC-Bausteins Am2960 dahingehend analysiert, welche Konfigurationen von mehrals-2-stelligen Fehlern, vgl. die bereits erläuterte Fig. 4, von diesem Baustein als Fehler zuverlässig sofort erkannt werden, und welche Konfigurationen solcher Fehler nicht mehr erkannt werden. Daraufhin wurde die Verschachtelung der Einfügung der Schaltungsanordnungen in die Adern so gewählt, daß zuverlässig durch den Ausfall eines beliebigen der Bausteine B1...B6 jeweils nur Konfigurationen von fehlerhaften Bitstellen entstehen können, die alle stets mit 100 %iger Sicherheit vom EDC-Baustein EDC sofort als Fehler erkannt werden.

Bei dieser Auswahl einer günstigen Verschachtelung wurde festgestellt, daß auch eine größere Anzahl verschiedener Verschachtelungen möglich sind, um die angestrebte 100 %ige Sicherheit der Erkennung des Ausfalls eines beliebigen der Bausteine B1...B6 zu erreichen. Im Patentanspruch 4 ist eine zweite Variante angegeben für die Einfügung von, jeweils vier = n Schaltungsanordnungen enthaltenden, Schaltungsanordnungsbausteine B1...B6 bei sechszehnstelligen Informationsbits IB und sechsstelligen Paritätbits PB für denselben EDC-Baustein Am2960. Eine 100 %ige Sicherheit zur Erkennung des Ausfalls eines dieser sechs Bausteine besteht also z.B. auch dann, wenn die Schaltungsanordnungen des ersten Bausteins B1 die Informationsbitstellen IB0, IB2, IB6 und IB10, ferner die Schaltungsanordnungen des zweiten Bausteins B2 die Informationsbitstellen IB1, IB5, IB12 und IB13, ferner die Schaltungsanordnungen des dritten Bausteins B3 die Informationsbitstellen IB3, IB4, IB7 und IB14, ferner die Schaltungsanordnungen des vierten Schaltungsanordnungsbausteins B4 die Informationsbitstellen IB8, IB9, IB11 und IB15, ferner die Schaltungsanordnungen des fünften Bausteins B5 die Paritätbitstellen PB0, PB1, PB2, sowie die Schaltungsanordnungen des sechsten Bausteins B6 die Paritätbitstellen PB3, PB4 und PB5 übertragen. Hier handelt es sich also um eine erfindungsgemäße Bitübertragungsanordnung, bei der die drei Bausteine B4, B5 und B6 jeweils sogar drei von - jeweils für den betreffenden Baustein betrachtet - vier benachbarten Eingangsstellen des EDC-Bausteins- Am2960 übertragen, wobei aber trotzdem bereits eine 100 %ige Sicherheit der sofortigen Erkennung des Ausfalls eines der sechs Bausteine B1...B6, entsprechend ein- bis vierstelligen Fehlern, erreicht ist.

Eine Vielzahl weiterer anderer erfindungsgemäßen Varianten sind leicht durch Versuche und insbesondere durch Berechnungen findbar, und zwar sogar eine Mehrzahl weiterer solcher Varianten, bei denen sogar eine 100 %ige Sicherheit der sofortigen Erkennung des Ausfalls eines der Bausteine B1...B6 erreicht wird.

Je weniger Schaltungsanordnungen die betreffenden Schaltungsanordnungsbausteine jeweils enthalten, um so eher lassen sich erfindungsgemäße Verschachtelungen finden, insbesondere solche erfindungsgemäße Verschachtelungen, die eine 100 %ige Sicherheit der sofortigen Erkennung des Ausfalls eines solchen Bausteins gewährleisten. So ist die Verwendung von Schaltungsanordnungsbausteinen , welche nur drei oder nur vier Stellen der Bits des zu übertragenden Wortes parallel übertragen können, besonders günstig, weil dann besonders schnell solche günstigen erfindungsgemäßen Lösungen gefunden werden, welche sogar eine 100 %ige sofortige Erkennung eines Bausteinausfalls gewährleisten.

## Ansprüche

1. Vieladrige Bitübertragungsanordnung zur parallelen Übertragung eines nach einem EDC-Prinzip gesicherten Wortes aus Informationsbits (IB) und Paritätsbits (PB),
   wobei am Eingang der Übertragungsstrecke an jeder deren Adern (IB0...15, PB0...5) eine bitindividuelle Schaltungsanordnung und am Ende der Übertragungsstrecke, eine dem gewählten EDC-Prinzip entsprechende EDC-Schaltung (EDC) angebracht ist, die beliebige Vielfachfehler bis zu einer bestimmten Größe mit 100%iger Sicherheit erkennt,
   **dadurch gekennzeichnet, daß**
   - zumindest ein Großteil der parallel betriebenen bitindividuellen Schaltungsanordnungen auf mehrere Schaltungsanordnungsbausteine (B1...6), die jeweils bis zu n parallel betriebene bitindividuelle Schaltungsanordnungen enthalten, so verteilt sind, daß bei Ausfall eines Schaltungsanordnungsbausteins nur solche speziellen Konfigurationen von Vielfachfehlern über der bestimmten Größe auftreten können, die die betreffende EDC-Schaltung (EDC) mit hoher Sicherheit erkennt.

2. Bitübertragungsanordnung nach Patentanspruch 1, bei der das gewählte EDC-Prinzip eine SEC/DED-Sicherung gewährleistet,
   **dadurch gekennzeichnet, daß**
   - die Schaltungsanordnungsbausteine (B1...6) Verstärkerbausteine sind, die jeweils 4 bitindividuelle Schaltungsanordnungen enthalten.

## Claims

1. Multiwire bit transmission arrangement for the parallel transmission of a word protected according to an EDC principle and consisting of information bits (IB) and parity bits (PB), in which a bit-specific circuit arrangement is provided at the input of the transmission path at each of its wires (IB0...15, PB0...5), and an EDC circuit (EDC) which corresponds to the selected EDC principle and which detects any multiple errors up to a defined magnitude with 100% reliability is provided at the end of the transmission path, characterised in that at least a majority of the parallel-operated, bit-specific circuit arrangements are distributed to a plurality of circuit arrangement modules (B1...6), which contain up to n parallel-operated, bit-specific circuit arrangements in each case, in such a way that when a circuit arrangement module fails, only those special configurations of multiple errors above the defined magnitude which the respective EDC circuit (EDC) detects with a high degree of reliability can occur.

2. Bit transmission arrangement according to Patent Claim 1, in which the selected EDC principle ensures SEC/DED protection, characterised in that the circuit arrangement modules (B1...6) are amplifier modules containing 4 bit-specific circuit arrangements in each case.

## Revendications

1. Dispositif multifilaire de transmission de bits pour la transmission en parallèle d'un mot protégé selon le principe DE DETECTION ET DE CORRECTION D'ERREURS (EDC) et constitué par des bits d'information (IB) et des bits de parité (PB),
   et dans lequel un circuit prévu pour chaque bit est disposé à l'entrée de la section de transmission, dans chacun des conducteurs (IB0...15, PB0...5) de cette section, tandis qu'à l'extrémité de la section de transmission est disposé un circuit de détection et de correction d'erreurs (EDC) (DE DETECTION ET DE CORRECTION D'ERREURS), qui est basé sur le principe DE DETECTION ET DE CORRECTION D'ERREURS choisi et identifie des erreurs multiples quelconques jusqu'à une taille déterminée, et ce avec une sécurité à 100 %, caractérisé par le fait

- qu'au moins une partie importante des circuits fonctionnant en parallèle et prévus pour les différents bits, sont répartis entre plusieurs modules de circuits (B1...6), qui contiennent respectivement jusqu'à n circuits fonctionnant en parallèle et prévus pour les différents bits, de sorte que, lors de la défaillance d'un module de circuits, seules peuvent apparaître des configurations particulières d'erreurs multiples dépassant une taille déterminée, que le circuit considéré de détection et de correction d'erreurs (EDC) (DE DETECTION ET DE CORRECTION D'ERREURS) identifie d'une manière très sûre.

2. Dispositif de transmission de bits suivant la revendication 1, dans lequel le principe DE DETECTION ET DE CORRECTION D'ERREURS choisi garantit une sécurité SEC/DED de correction d'erreurs simples et de détection d'erreurs doubles, caractérisé par le fait

- que les modules de circuits (B1...6) sont des modules d'amplificateurs, qui contiennent chacun 4 circuits prévus pour les différents bits.

FIG 1

M

IB
EDC
PB

IB = 16 bit
PB = 6 bit

B1...B6

PN

P

# FIG 2

# FIG 3

# FIG 4

| Fehler | nichterkannte Fehler | | $\binom{22}{j}$ mit j=3…8; (22=16+6) |
| | absolut | % | |
| --- | --- | --- | --- |
| 3 | 1008 | 65,5 | 1540 |
| 4 | 252 | 3,4 | 7315 |
| 5 | 18264 | 69,4 | 26334 |
| 6 | 2288 | 3,1 | 74613 |
| 7 | 116976 | 68,6 | 170544 |
| 8 | 10046 | 3,1 | 319770 |